# EUROPEAN PATENT APPLICATION

(11) **EP 4 618 148 A1**
(43) Date of publication of application: **17.09.2025**
(21) Application number: 24163312.2
(22) Date of filing: 13.03.2024
(51) Int. Cl.: H01L 23/538

(54) **A COMPONENT CARRIER ASSEMBLY AND METHOD FOR MANUFACTURING A COMPONENT CARRIER ASSEMBLY**

(71) Applicant: AT & S Austria Technologie & Systemtechnik Aktiengesellschaft, 8700 Leoben-Hinterberg (AT)
(72) Inventor: WILDING, Dominik, 8720 Knittelfeld (AT)
(74) Representative: Burger, Hannes

(57) **Abstract**

The invention relates to a component carrier assembly (1) with a component carrier (2) comprising a stack (4) of at least one electrically conductive layer structure (5) and at least one electrically insulating layer structure (6).

It further comprises a component (10), preferably an electronic component, being at least partially embedded within the stack (4) and comprising a first main surface (11), a second main surface (12) opposed to the first main surface (11), and at least one lateral surface (13) connecting the first main surface (11) and the second main surface (12) with each other, wherein a first edge (14) is formed where the first main surface (11) and the at least one lateral surface (13) meet and a second edge (15) is formed where the second main surface (12) and the at least one lateral surface (13) meet.

An adhesive profile (3) is provided in the region of the first edge (14) of the component (10).

## Description

The invention relates to a component carrier assembly comprising a stack of a plurality of layers forming at least one electrically conductive layer structure and at least one electrically insulating layer structure, said stack comprising a cavity. The invention also relates to a component carrier assembly and to a method for manufacturing a component carrier.

According to the prior art, it is known to attach an electronic component, for example, a chip or the like, to a component carrier. The components are often attached to carrier materials by soldering, gluing or the like. Some of them are freely accessible on the carriers or may also have a protective cover.

The US 10483181B2 discloses a package comprising a support plate and an electronic integrated circuit chip mounted on the support plate via a layer of glue, an encapsulation cap that with the support plate delimits at least one chamber in which the electronic integrated circuit chip is situated, wherein at least one bead of glue is inserted between a peripheral zone of the support plate and an end edge of a peripheral wall of the encapsulation cap.

It has been the object of the present invention to overcome the disadvantages of the prior art and to provide a component carrier assembly and method by means of which a component should be protected by the carrier on the one hand and should provide an improved fixation of the component in the component carrier assembly on the other hand.

This object is achieved by a component carrier assembly comprising a stack of at least one electrically conductive layer structure and at least one electrically insulating layer structure, and a component, preferably an electronic component, said component being at least partially, preferably fully, embedded within the stack and comprising a first main surface, a second main surface opposed to the first main surface, and at least one lateral surface connecting the first main surface and the second main surface with each other, wherein a first edge is formed where the first main surface and the at least one lateral surface meet and a second edge is formed where the second main surface and the at least one lateral surface meet. A - preferably continuously extending - adhesive profile is provided in the region of, preferably direct at, the first edge of the component.

The present invention enables an embedding of the component in the component carrier, wherein the component can be better protected during the manufacturing of the component carrier assembly. Furthermore, a protection zone can be provided by the adhesive profile (for the component) which also improves the stability of the component. A further advantage of the adhesive profile is that it can also be used as an assembly aid for inserting the component.

As a further possible advantage, a direct physical/electrical connection to one main surface (preferably the first main surface) without vertical through-connections can be enabled.

The adhesive profile may comprise at least one material selected from the following; a resin, a fluorinated epoxy resin, a semi-cured resin. The semi-cured resin may comprise organic polymeric material, for example epoxy resin, poly (meth)acrylate, polyethylene theraphthalate, polyimide, of a mixture thereof.

Furthermore, the semi-cured resin may comprise reinforcing material, for example particles, comprising inorganic material, for example glass and/or ceramic.

Preferably, the semi-cured resin may have a viscosity of less than 10^4 Pa*s, preferably less than 5000 Pa*s at room temperature.

Furthermore, the adhesive profile may comprise a two-component adhesive.

In a further possible embodiment, a pre-hardening of the adhesive (or defined areas of adhesive), preferably with UV light, may be provided

The component may be an electronic or non-electronic component, an active or passive component.

The at least one component can be selected from a group consisting of an electrically nonconductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insu-lating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminum oxide (Al2O3) or aluminum nitride (AlN). In order to increase the heat exchange capacity, other geometries with increased surface area are frequently used as well. Furthermore, a component can be an active electronic component (having at least one p-n-junction implemented), a pas-sive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic ar-ray logic (GAL) and complex programmable logic devices (CPLDs)), a signal processing com-ponent, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga2O3), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electrome-chanical transducer, a sensor, an actuator, a microelectromechanical system (MEMS), a micro-processor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be an IC substrate, an interposer or a further component carrier, for example in a board-in-board con-figuration. The component may be surface mounted on the component carrier and/or may be embedded in an interior thereof. Moreover, also other components, in particular those which generate and emit electromagnetic radiation and/or are sensitive with regard to electromagnet-ic radiation propagating from an environment, may be used as component.

Preferably, the electronic component comprises a chip and/or an integrated circuit (IC). The electronic component may be an active device, but may also be a passive device such as a capacitor, an inductor, or a resistor, or a combination thereof.

The component may have a non-planar lateral surface, for example a concave or convex surface, or an inclined surface. The first (or second) main surface can also be non-planar.

Another advantage of the invention is that a double-sided direct fan embedding concept can be provided, for example, a fan out and/or a fan in. In a possible embodiment, no metal layer on the component back side may be needed, and/or no further processing steps (e.g. laser process) are needed for the component connection, which leads to a sensitive process for embedded components, which leads to a simple and efficient design of a component carrier.

Furthermore, a very thin build up may be possible with the present invention.

In an embodiment, the second edge is free of an adhesive profile, preferably free from adhesive, wherein preferably the whole second main surface is free from adhesive. This may bring the advantage of utilizing the entire second main surface of the component for electrical connection(s) or thermal connections.

Preferably, the component may be fully embedded within the stack, and the second edge is covered by at least one layer structure of the stack, wherein preferably the second edge is in contact with at least one layer structure of the stack.

In a further embodiment, the component may comprise a surface modification to improve the adhesive properties between the component and the adhesive profile, for example an increased/enlarged effective contact surface, preferably in an area of the first edge (or in an area which is in contact with the adhesive profile). The component may comprise several surface elements for example, fins, bars or the like, which are spaced apart from each other, to increase the effective surface area in relation the adhesive profile, for example, by providing small openings between the surface elements.

According to one embodiment, said adhesive profile connects the component (preferably the first edge of the component) and a portion of the stack, preferably a layer structure or a core of the stack, with each other. Thus, an improved embedding of the component can be provided (between the layers).

A core is preferably a provided element which has at least one electrically insulating layer and preferably at least one electrically conductive layer. The core may comprise reinforcing structure, for example glass fibres or glass spheres, and may be in a fully cured stage. Thus, it may provide mechanical stability to the stack.

Preferably, the first main surface and/or the second main surface, preferably at least the second main surface, may comprise(s) at least one electrically conductive surface portion, preferably a plurality of electrically conductive portions, for establishing an electrical connection to a functional part of the component. Using the described manufacturing method, an easy and reliable connection to at least one main surface may be established.

Preferably an active surface portion of the component defines the portion of the edge where at least one electrically conductive surface portion is provided. An active surface portion may preferably be a part or a surface of the component which comprises and/or can be brought into contact with functional elements or the like, such that the active surface portion does not only define a geometric shape of the component.

Preferably said active surface defines the portion of the second edge free of the adhesive profile.

Preferably, each one of the main surfaces of the component is an active surface comprising at least one electrically conductive surface.

Preferably, the adhesive profile is in contact with the first edge. This may bring the advantage of reliably holding the component in the desired place, while at the same time establish a chemical and/or physical connection.

In an advantageous embodiment, the adhesive profile partially covers the first main surface and/or partially covers the at least one lateral surface. The adhesive profile can provide a sealing effect to avoid the flowing of the embedding mass toward the central portion of the main surface of the component (i.e., not reaching a conductive portion on said main surface or a respective sensitive portion, i.e., an optical functional area).

In another embodiment, the adhesive profile is planar on a first side, wherein preferably the first side faces away from the component, and is not planar (preferably with regard to a main extension direction/ to a width extension) on a second side opposed to the first side, wherein preferably the second side is in contact with the component. With a planar surface, an improved embedding of the component can be provided, as well as an improved alignment of the component via the adhesive profile. A non-planar second side may comprise a combination of at least two different surfaces (opposed to the first side), for example, viewed in cross-section, the second side may be interrupted and/or may comprise a step portion or multiple surfaces with different height levels.

However, "not planar" may still comprise planar portions in main extension direction / perpendicular to stacking direction. Additionally, the term (not planar) may comprise undulated and/or bend portion (when viewed in cross-section). The second side may also comprise inclined portions.

According to a preferred embodiment, the adhesive profile is distanced from the first edge. The adhesive profile can form a spacer element for the component and be also distanced to the edge, wherein the embedding mass can flow around the first edge to provide an improved embedding.

Preferably, the adhesive profile is in contact with at least one electrically insulating layer structure of the stack and/or with at least one electrically conductive layer structure of the stack. This may bring the advantage of using well known PCB related manufacturing processes resulting in low amount of scrap.

According to an embodiment, the adhesive profile is in contact with the component. Direct contacting the component with the adhesive profile may enhance the accuracy of placement of the component inside the component carrier and thus may help establishing smaller component carrier design due to the higher accuracy.

In another embodiment, the surface of the adhesive profile that faces away from the component is distanced from the first main surface of the component and/or wherein the first main surface is distanced from the layer structure to which the adhesive profile connects the component. With this adaptation, a slot can be provided under the profile for further possible elements.

Preferably, the adhesive profile has a frame shape and/or is a closed profile and/or is composed of a plurality of detached profiles and/or is in form of at least one spot, in particular a plurality of spots. By providing a closed profile, a sealing effect can be achieved, to avoid the flowing of the embedding mass toward the central portion of the main surface of the component. With a detached profile or a profile formed by spots, it is possible to provide stable component connection using less adhesive material.

Furthermore, the adhesive layer and the component may be arranged at least partly, preferably fully, within a core and/or built-up structure of the stack and/or arranged on a core and/or built-up structure of the stack. According to this embodiment, a simplified provision of the component with the adhesive profile for its connection to a stack - to be manufactured - can be achieved.

According to one embodiment, the adhesive profile extends along the outer contour, preferably along the complete outer contour, of the first main surface. This embodiment enables the component to be positioned and aligned particularly smoothly via the adhesive profile.

Preferably, the adhesive profile encloses an internal, preferably planar, space. This enables a simplified geometric design of a space, to create a regular hollow space under the component via the adhesive profile (and the component). With this embodiment, a space can be provided for inserting different materials for different functions. Furthermore, a geometric shape of the provided space can be defined by the adhesive profile.

In another advantageous embodiment, at least one further adhesive profile is provided within the internal space, wherein preferably said further adhesive profile connects the component and a layer structure of the stack with each other and/or surrounds a functional portion of the component on the first main surface, preferably at least one electrically conductive surface portion for establishing an electrical connection to a functional part within the component. This design enables the formation of sub-divided spaces so that, for example, different materials can be inserted in the spaces or material can be selectively inserted into a space.

In one embodiment, the internal space is empty. This may bring the advantage of saving material and thus reducing the mass of the component carrier.

Alternatively, the internal space may at least be partially filled with a material different from the material the adhesive profile is formed from, wherein preferably the material within the internal space comprises a metal, in particular copper, and/or an insulating material and/or residues, particularly from a temporary layer, and/or a material with a functional property, wherein preferably the functional property comprises transparency, mechanical reinforcement, heat dissipating, antenna property and/or high frequency structure. This may provide the advantage of enlarging the scope of the usage of the component carrier, since many different functionalities may be involved.

Preferably the material within the internal space is an electrically conductive material, preferably copper, and is electrically coupled to at least one electrically conductive layer structure of the stack, preferably through at least one vertical connection, and/or to at least one electrically conductive surface portion of the component. This may provide the advantage that the connection to or from the component does not require additional space and due to the use of copper a reliable electrical and or thermal connection may be established.

The object of the invention is also achieved by a method for manufacturing a component carrier, the method comprising the steps of, preferably in the following order;
(a) providing a component, preferably an electronic component, said component comprises a first main surface, a second main surface opposed to the first main surface, and at least one lateral surface connecting the first main surface and the second main surface with each other, wherein a first edge is formed where the first main surface and the at least one lateral surface meet and a second edge is formed where the second main surface and the at least one lateral surface meet,
(b) providing a - preferably continuously extending - adhesive profile, in the region of, preferably direct at, the first edge of the component,
(c) forming a component carrier comprising a stack of at least one electrically conductive layer structure and at least one electrically insulating layer structure, with the component being at least partially, preferably fully, embedded within the stack.

The present invention enables an embedding of the component in the component carrier, wherein the component can be better protected during the manufacturing of the component carrier assembly. Furthermore, a protection zone can be provided by the adhesive profile (for the component) which also improves the stability of the component.

According to an embodiment, step (b) comprises applying the adhesive layer, preferably by printing, in particular 3D printing and/or screen printing, and/or dispensing and/or laminating an adhesive foil followed by a structuring process, for example by laser exposure and/or plasma treatment, to a base layer, preferably a metal foil, and/or to the component, and connecting the base layer and the component with each other via the adhesive profile, wherein preferably the adhesive profile encloses an internal space between base layer and first main surface of the component, wherein preferably the internal space is completely sealed to the outside. This may provide reliable connection of the component to the stack via the adhesive layer.

Preferably, step (c) comprises building up the stack onto the base layer.

In one preferred embodiment step c) comprises removing, preferably by etching, at least partially, preferably fully, the base layer from the stack, such that the first main surface of the component becomes exposed at least partially. This may create an easy access to the internal space.

In another embodiment, step (c) comprises applying material, preferably electrically conductive material, to the internal space enclosed by the adhesive profile and/or to the first main surface of the component. This may establish an electrical and/or thermal connection from or to the component in an easy way by using PCB related manufacturing machines.

According to one preferred embodiment, step (c) comprises establishing an electrical connection to at least one electrically conductive portion of the component through the internal space enclosed by the adhesive profile, preferably an electrical connection between at least one electrically conductive portion of the component and an electrically conductive layer structure of the stack.

As already mentioned, the adhesive profile may comprise a two-component adhesive. Preferably, the adhesive profile made be partially provided; separated into each of its two components, wherein one can be provided on the component and the other one can be provided on the stack, wherein the two components merge into each other when component is inserted into the stack.

The step of providing the adhesive profile may include a further step of pre-hardening of the adhesive (or defined areas of adhesive), preferably with UV light.

It is understood that a "material" in the sense of the present application may comprise one or more type(s) of element(s). It is further understood, that even if two of the (first, second and third) materials comprise the same element, but differ in another element and/or in composition and/or in element ratio, they are considered as being different from each other. For example, if the first material is a TiW alloy and second material is Ti, they are of course different to each other.

In the context of the present application, the term "component carrier assembly" is understood as a combination of a component carrier and at least one electronic component.

In the context of the present application, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, and an IC (integrated circuit) substrate. A component carrier may also be a hybrid board combining different ones of the above mentioned types of component carriers.

In the context of the present application, the term "stack" may particularly denote an arrangement of multiple planar layer structures which are mounted in parallel on top of one another. It may comprise at least one electrically insulating layer structure and at least one electrically conductive layer structure. For example, the stack may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components. In an example, the stack may be nevertheless very thin and compact. In another example, the stack may be very thick for a high-density product. The stacking direction (height/thickness) may be arranged in the vertical direction z. Further, the stacking direction may be perpendicular to the two directions of main extension (along x and y) of the (plate-shaped) component carrier.

In the context of the present application, the term "layer structure" may particularly denote a continuous or discontinuous layer, a patterned layer or a plurality of non-consecutive islands within a common plane. A plurality of such layers, parallel stacked one upon the other, may form the stack in the vertical direction.

In the context of the present application, the term "main surface" of a body may particularly denote one of two largest opposing surfaces of the body. The main surfaces may be connected by circumferential side walls. The thickness of a body, such as a stack, may be defined by the distance between the two opposing main surfaces.

Preferably, the component carrier assembly is a printed circuit board (PCB) and/or a substrate (such as an IC substrate) and/or an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In an embodiment, the at least one electrically insulating layer structure comprises at least one of the group, consisting of a resin or a polymer, such as epoxy resin, cyanate ester resin, benzocyclobutene resin, bismaleimidetriazine resin, polyphenylene derivate (for example based on polyphenylenether, PPE), polyimide (PI), polyamide (PA), liquid crystal polymer (LCP), polytetrafluoroethylene (PTFE) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, for example fibers impregnated with the above-mentioned resins is called prepreg. These prepregs are often named after their properties for example FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

According to a further possible embodiment, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

To provide better understanding of the invention, the invention is explained in more detail with the aid of the following figures.

The following is shown in a strongly simplified, schematic representation:
- Fig. 1: an embodiment of a component carrier;
- Fig. 2: an embodiment of an intermediate product with a base layer;
- Fig. 3: an embodiment of an intermediate product with an applied adhesive profile;
- Fig. 4: an embodiment of an intermediate product with an inserted component;
- Fig. 5: an embodiment of an intermediate product with applied electrically insulating layer structure;
- Fig. 6: an embodiment of an intermediate product in a joining step;
- Fig. 7: an embodiment of an intermediate product with removed base layer;
- Fig. 8: an embodiment of an intermediate product with applied electrically conductive layer;
- Fig. 9: an embodiment of a component carrier assembly;
- Fig. 10: a further embodiment of a component carrier assembly;
- Fig. 11: another embodiment of a component carrier assembly;
- Fig. 12: a) and b) an embodiment of the adhesive layer;
- Fig. 13: an embodiment of the adhesive layer.

As an introduction, it should be noted that in the embodiments described in different ways, identical parts or method steps are indicated with identical reference numbers or identical component designations; at the same time, the disclosures contained in the entire description may be analogously applied to identical parts with identical reference numbers or identical component designations. Moreover, the position indications chosen in the description, such as at the top, at the bottom, laterally, etc. refer to the figure which is directly represented and described; and if a position changes, said position indications are to be applied analogously to the new position.

The embodiments show possible variants; however, it should be noted at this point that the invention is not limited to the variants specifically shown; rather, various combinations of the individual variants are possible as well, and, due to the technical information provided by the present invention, this variation possibility is subject to the skills of the person skilled in the art who works in this technical field.

The scope of protection is determined by the claims. However, the description and the drawings are to be used for construing the claims. Individual features or feature combinations from the different embodiments that are shown and described may per se constitute independent solutions according to the invention. The object underlying the independent solutions according to the invention may be gathered from the description.

For the sake of good order, it should finally be noted that, for better understanding, some of the facts shown in the figures have been represented unscaled and/or enlarged and/or in reduced size.

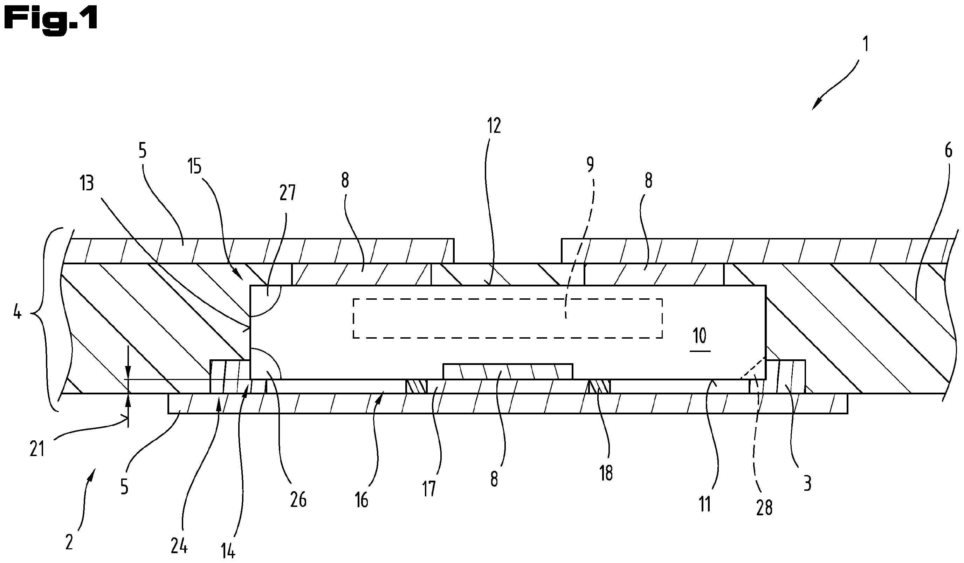

Fig. 1 shows a carrier assembly 1 comprising a component carrier 2 with a stack 4 of at least one electrically conductive layer structure 5 and at least one electrically insulating layer structure 6.

It further comprises a component 10, preferably an electronic component, said component being at least partially, preferably fully, embedded within the stack 4 and comprising a first main surface 11, a second main surface 12 opposed to the first main surface 11, and at least one lateral surface 13 connecting the first main surface 11 and the second main surface 12 with each other, wherein a first edge 14 is formed where the first main surface 11 and the at least one lateral surface 13 meet and a second edge 15 is formed where the second main surface 12 and the at least one lateral surface 13 meet and wherein a - preferably continuously extending - adhesive profile 3 is provided in the region of, preferably direct at, the first edge 14 of the component 10 as shown in Fig. 1.

In an example, between the first main surface 11 and the lateral surface 13 a first angle 26 may be enclosed in the range from 45° to 135°, in particular in the range from 70° to 110°. Additionally, or alternatively, between the second main surface 12 and the lateral surface 13 a second angle 27 may be enclosed in the range from 45° to 135°, in particular in the range from 70° to 110°.

As mentioned before, the second edge 15 may be free of an adhesive profile, preferably free from adhesive, wherein preferably the whole second main surface 12 is free from adhesive. Alternatively, the second edge 15 and optionally the second main surface 12 may be covered by the adhesive.

Preferably, the component 10 can be fully embedded within the stack 4, and the second edge 15 is covered by at least one layer structure 5, 6 of the stack 4, wherein preferably the second edge 15 is in contact with at least one layer structure 5, 6 of the stack 4.

As shown, the adhesive profile 3 preferably connects the component 10 and a portion of the stack 4, preferably a layer structure 5, 6 (or core) of the stack 4, with each other. Additionally, the adhesive profile 3 may connect the component 10 and a further component and a portion of the stack, wherein the component and the further component may be distanced from each other.

The first main surface 11 and/or the second main surface 12, preferably at least the second main surface 12, comprises at least one electrically conductive surface portion 8, preferably a plurality of electrically conductive portions 8, for establishing an electrical connection to a functional part 9 of the component 10.

As further shown in Fig. 1 the adhesive profile 3 is preferably in contact with the first edge 14, preferably especially such that the adhesive profile 3 partially covers the first main surface 11 and/or partially covers the at least one lateral surface 13.

The adhesive profile 3 may be planar on a first side, preferably a surface 24, wherein preferably the first side faces away from the component 10, and may be not planar on a second side opposed to the first side, wherein preferably the second side is in contact with the component 10. In a further example, the first side and the second side may both be planar or not planar.

As mentioned above, the adhesive profile 3 is preferably in contact with the component 10.

In a further embodiment, - independent of the embodiment shown -, the component 10 may comprise a surface modification to improve the adhesive properties between the component and the adhesive layer, for example an increased/enlarged effective contact surface, preferably in an area of the first edge 14 (or in the area that is in contact with the adhesive profile).

Also independent of the embodiment shown, the component may further comprise several surface elements 28 - as indicated with dashed lines in Fig. 1-, for example, micro-fins, bars or the like, to increase the effective surface area in relation the adhesive profile, for example, by providing small openings between the surface elements, wherein said openings may preferably have the same shape as the surface elements 28. The surface elements 28 may be arranged in the area of the first edge, at least partially, preferably distributed over the whole circumference, of the component 10 (with respect to the extension of the adhesive profile). The surface elements may be similar, preferably identical, repetitively arranged elements.

Furthermore, a two-component adhesive may be used for the adhesive profile as already mentioned, wherein one of its two components can be applied to the surface modification mentioned above.

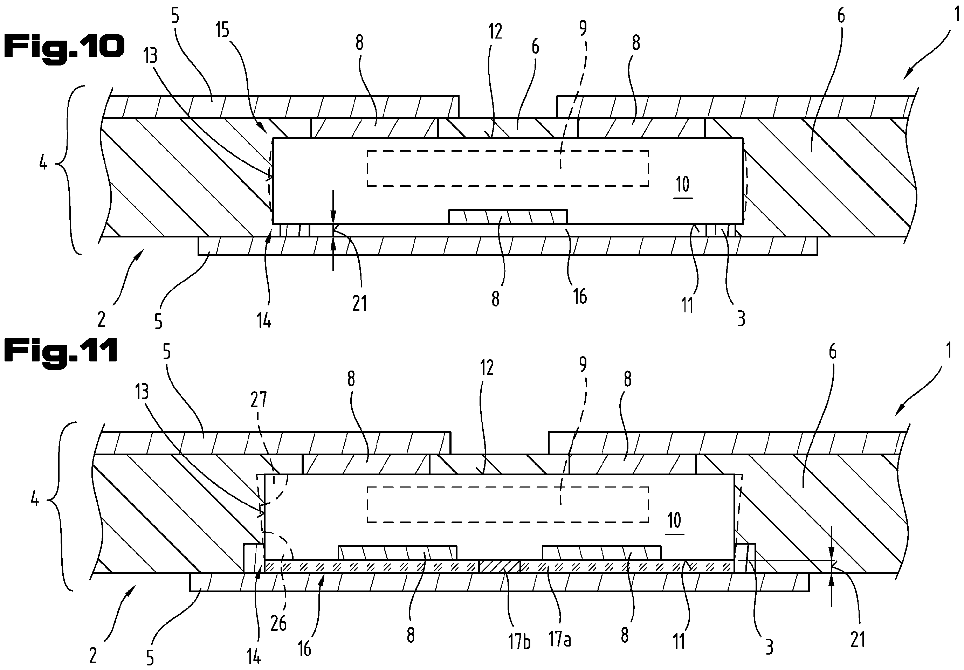

According to one embodiment, the adhesive profile 3 may also be distanced from the first edge 14 as it is shown in Fig. 10 (independent of the embodiment shown).

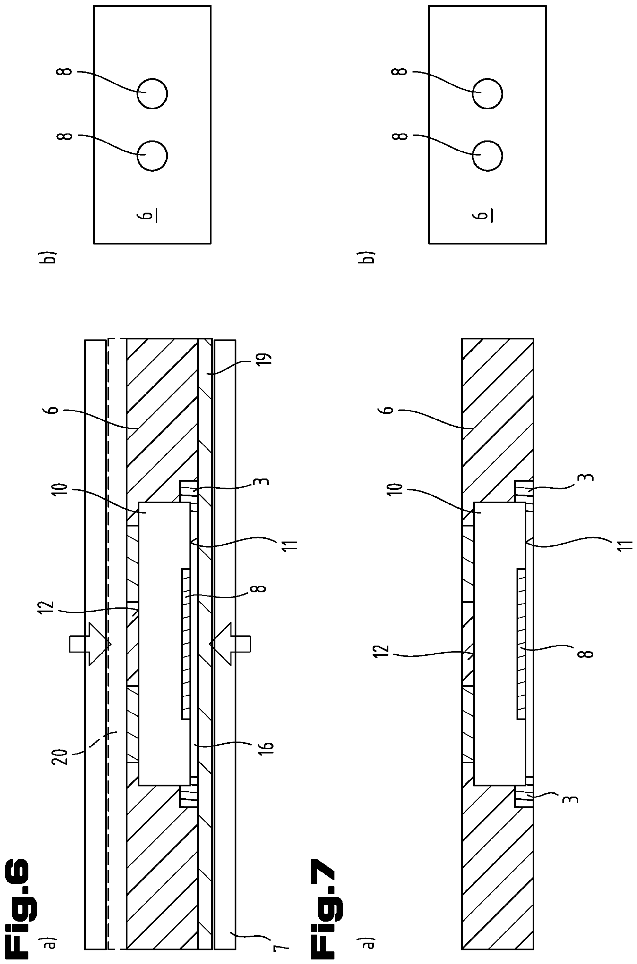

The adhesive profile 3 is preferably in contact with at least one electrically insulating layer structure 6 of the stack 4 and/or with at least one electrically conductive layer structure 5 of the stack 4. The adhesive profile 3 is preferably entirely embedded. Alternatively, at least a portion of the adhesive profile 3 may be exposed (shown in Fig. 7).

Preferably the first side (e.g., the surface 24) of the adhesive profile 3 that faces away from the component 10 is distanced from the first main surface 11 of the component 10 and/or the first main surface 11 is preferably distanced from the layer structure 5, 6 to which the adhesive profile 3 connects the component 10. Therefore, a distance 21 is shown, which distance 21 is formed between the main surface and the surface 24 of the adhesive profile that faces away from the component 10. In an example, the distance 21 may be smaller than 10 µm. Alternatively, the distance 21 may be in the range from 10 µm to 50 µm.

The adhesive profile 3 has preferably a frame shape and/or is a closed profile and/or is composed of a plurality of detached profiles and/or is in form of at least one spot, in particular a plurality of spots. In one embodiment, the adhesive profile 3 extends along the outer contour, preferably along the complete outer contour, of the first main surface 11.

Preferably, the adhesive layer 3 and the component 10 are arranged at least partly, preferably fully, within a core (preferably comprising at least one electrically insulating structure and at least one electrically conductive layer structure) and/or built-up structure of the stack 4 and/or arranged on a core and/or built-up structure of the stack 4.

The adhesive profile 3 preferably encloses an internal, preferably planar, space 16.

According to one embodiment, the internal space 16 may be empty, as it is shown in Fig. 10.

In an alternative embodiment" the internal space 16 is at least partially filled with a material 17 different from the material of the adhesive profile 3 is formed from, wherein preferably the material within the internal space 16 comprises a metal, in particular copper, and/or an insulating material and/or residues, particularly from a temporary layer, and/or a material with a functional property, wherein preferably the functional property comprises transparency, mechanical reinforcement, heat dissipating, antenna property and/or high frequency structure.

Preferably, the material 17 within the internal space 16 is an electrically conductive material, preferably copper, and is electrically coupled to at least one electrically conductive layer structure 5 of the stack 4, preferably through at least one vertical connection, and/or to at least one electrically conductive surface portion 8 of the component 10.

As further shown in Fig. 1 (also independent of the embodiment shown), at least one further adhesive profile 18 may be provided within the internal space 16, wherein preferably said further adhesive profile 18 connects the component 10 and a layer structure 5, 6 of the stack 4 with each other and/or may surround a functional portion 8 of the component 10 on the first main surface 11, preferably at least one electrically conductive surface portion for establishing an electrical connection to a functional part 9 within the component 10.

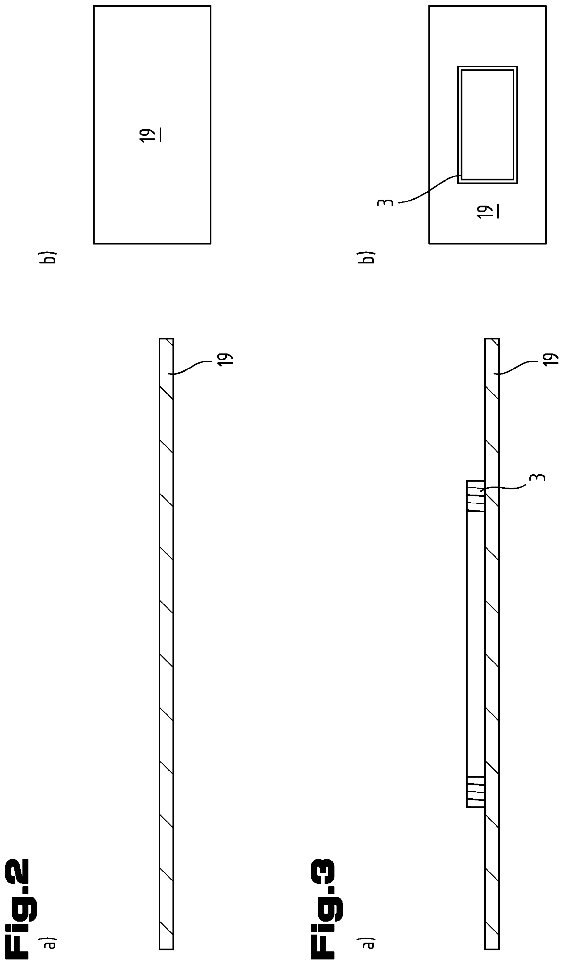

Fig. 2 to 9 show a possible method for manufacturing a component carrier assembly 1, wherein the intermediate product of the several steps is shown by a cross section view (Fig. a) and a top view (Fig. b).

The method shown in Fig. 2 to 9 comprises the steps of; (preferably in the following order)
(a) providing a component 10, preferably an electronic component, said component comprises a first main surface 11, a second main surface 12 opposed to the first main surface 11, and at least one lateral surface 13 connecting the first main surface 11 and the second main surface 12 with each other, wherein a first edge 14 is formed where the first main surface 11 and the at least one lateral surface 13 meet and a second edge 15 is formed where the second main surface 12 and the at least one lateral surface 13 meet,
(b) providing a - preferably continuously extending - adhesive profile 3, in the region of, preferably direct at, the first edge 14 of the component 10,
(c) forming a component carrier 2 comprising a stack 4 of at least one electrically conductive layer structure 5 and at least one electrically insulating layer structure 6, with the component 10 being at least partially, preferably fully, embedded within the stack 4.

According to a further possible embodiment, the step (b) -providing an adhesive profile 3 - may be carried out after the step (c) - forming a component carrier 2.

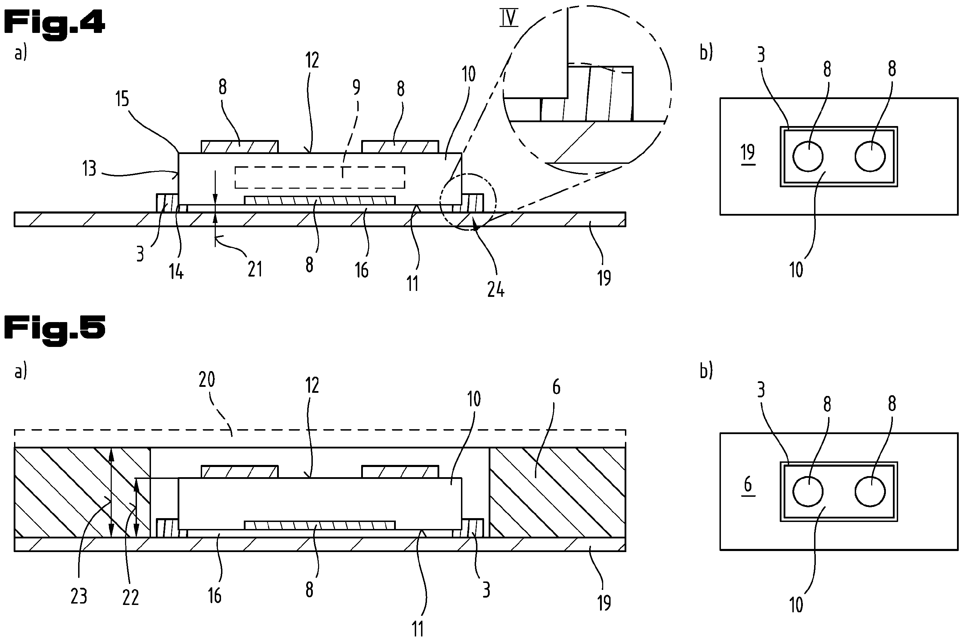

The step of - providing an adhesive profile 3 -, may comprise applying the adhesive layer 3, preferably by printing, in particular 3D printing and/or screen printing, and/or dispensing and/or laminating an adhesive foil followed by a structuring process, for example by laser exposure and/or plasma treatment, to a base layer 19, preferably a metal foil, and/or to the component 10, and connecting the base layer 19 and the component 10 with each other via the adhesive profile 3. Preferably, the adhesive profile 3 encloses an internal space 16 between base layer 19 and first main surface 11 of the component 10, wherein preferably the internal space 16 is completely sealed to the outside, as shown in Fig 4. As mentioned before, the step of forming the component carrier 2 may be carried out before the step of providing the adhesive profile 3 in the region of the first edge 14 of the component, for example, in a possible printing process, in such way that the component may be (at least partially) embedded within the stack, wherein the adhesive profile may be provided in a following step.

Preferably, step (c) comprises building up the stack onto the base layer.

Step (c) may comprise removing, preferably by etching, at least partially, preferably fully, the base layer from the stack, such that the first main surface of the component becomes exposed at least partially.

Step (c) may comprise applying material, preferably electrically conductive material, to the internal space enclosed by the adhesive profile and/or to the first main surface of the component.

The step of providing the adhesive profile may include a further step of pre-hardening of the adhesive (or defined areas of adhesive), preferably with UV light.

Alternatively, the adhesive profile 3 may be applied on the component 10 before connecting the component 10 and the base layer (not shown). Furthermore, the adhesive profile 3 can be partially applied on both, the base layer 19, and the component 10. The adhesive profile may comprise a two-component adhesive.

As it can be seen in Fig. 2b (or 3b) the adhesive profile 3 preferably may have a frame shape and/or a closed profile.

As mentioned before, the internal space 16 is preferably completely sealed to the outside.

As shown in Fig. 4a and 4b, the adhesive profile 3 preferably extends along the outer contour, preferably along the complete outer contour, of the first main surface 11.

The electronic component 10 preferably comprises electrically conductive portions 8 (here in the form of pads) at its second surface 12 for establishing an electrical connection to the functional part 9 of the electronic component 10. Additionally, in the exemplary embodiment the electronic component 10 comprises electrically conductive portions 8 also at its opposed first surface 11 for establishing a further electrically connection to the functional part 9 of the electronic component 10 and/or for heat distribution. The electrically conductive portions 8 may be the component pad or a layer overlapping said pad, preferably preventing exposure of said component pad. The conductive portions 8 may protrude from a main surface. Alternatively, the conductive portions 8 may be flush with a main surface or may be indented in a main surface.

The step of - forming a component carrier 2- may comprise building up the stack 4 onto the base layer 19.

As mentioned before, the adhesive profile 3 may be planar on the first side, preferably the surface 24, wherein the adhesive profile can be not planar on the second side -opposed to the first side-, wherein preferably the second side is in contact with the component 10.

As shown by the Detail IV in Fig. 4 (a), the non-planar (second) side may comprise a step portion, for example, in such way that the cross section of the adhesive profile may be formed like an "L". Additionally (or alternatively) as indicated by the dashed line, the second side may comprise undulated and/or bend portion (when viewed in cross-section).

With reference to the step portion, it may therefore be provided that the second side of its entirety may be not planar, but can be composed of several planar surfaces, preferably at right angles to each other (/preferably depending on the shape of the component).

At this point, it should be mentioned that such a geometric shape of the adhesive profile 3 may also be provided already before it is brought into contact with the component 10.

As shown in Fig. 5, preferably an insulting layer structure 6 and/or a core is applied on the base layer 19, wherein the mentioned core is also made at least partially of an insulating material, for example, but not limited to resin (FR4), glass, ceramics, etc. Preferably a thickness 23 of the insulation layer structure 6 (with respect to the base layer 19) is at least equal to a height 22 of the component 10, preferably slightly higher than the height 22 of the component 10, for example, preferably at least 5µm higher.

At this point it should be mentioned for completeness, that a layer structure comprising different layers, for example multiple electrically insulating and electrically conductive layers, can be applied one the base layer.

Furthermore, a temporary layer 20, in the form of a separation foil or the like, may be applied on the top of the intermediate product - facing the second surface 12 - before carrying out a joining step, preferably a pressing step, as the pressing step is shown in Fig. 6 with the indicated pressing tool 7.

After joining, the temporary layer is preferably removed, e.g., by stripping.

The base layer 19 may also be at least partially, preferably fully, removed - preferably by etching from the stack, such that the first main surface 11 of the component 10 becomes exposed, at least partially, as shown in Fig. 7. Alternatively, a plasma process, or chemical/mechanical grinding process may be used.

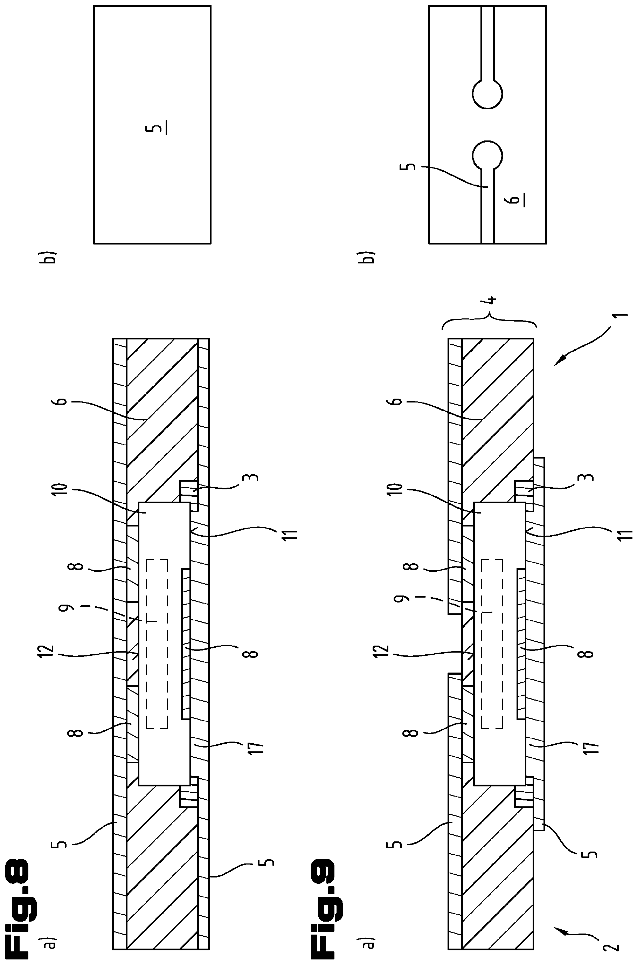

Referring to Fig. 8, at least one electrically conductive layer structure 5 is formed, such that the component 10 is at least partially, preferably fully, embedded within the stack. The at least one electrically conductive layer structure 5 may comprise an electrically insulating layer structure 6 and may be composed as a copper cladded electrically insulating layer sheet. The copper cladded electrically insulating layer sheet may be applied to the stack using a lamination process.

Furthermore, material 17, preferably electrically conductive material, may be applied to the internal space 16 enclosed by the adhesive profile 3 and/or to the first main surface 11 of the component 10.

A mask or another filler material can be inserted or applied in the internal space 16 instead (or additionally). A resin or an electrically insulating material can also be filled or applied in the space.

As already mentioned before, the step of - forming a component carrier 2 - may comprise establishing an electrical connection to at least one electrically conductive portion 8 of the component 10 through the space 16 enclosed by the adhesive profile 3, preferably an electrical connection between at least one electrically conductive portion 8 of the component 10 and an electrically conductive layer structure 5 of the stack 4.

In the case an electrically conductive layer 5 is provided on the top and/or bottom of the intermediate product, material of the layer 5 is selectively removed.. Selective removal may be done by using a laser beam, particularly an UV laser beam.

An electrically connection may be provided between the at least one electrically conductive portion 8 and a trace formed after the selectively removal (as shown in Fig.9a), a direct fan out (or fan in) structure can be provided (as shown in Fig.9b), for example.'

Alternatively selective removal may be done by applying a mask, preferably from photoresist, and subsequent etching. Optionally, after the material removal process, a cleaning or washing process may be applied, for example using a cleaning fluid, i.e., water or an organic solvent.

As indicated in Fig. 10 and 11 with dashed lines, the component 10 may have a non-planar lateral surface 13, for example a concave or convex surface, or an inclined surface. The first (or second) main surface can also be non-planar.

As shown in Fig. 11, the adhesive profile partially cover may cover only the peripheral surface 13 of the Component 10.

Independent of the embodiment shown in Fig. 11, a material 17 with specific properties, for example, but not limited to, transparent material, reinforcement material, antenna or HF structure may be inserted or filled (at least partially) in the space 16. As further indicated in Fig. 11, different materials 17a and/or 17b or elements may be inserted or filled in the space 16.

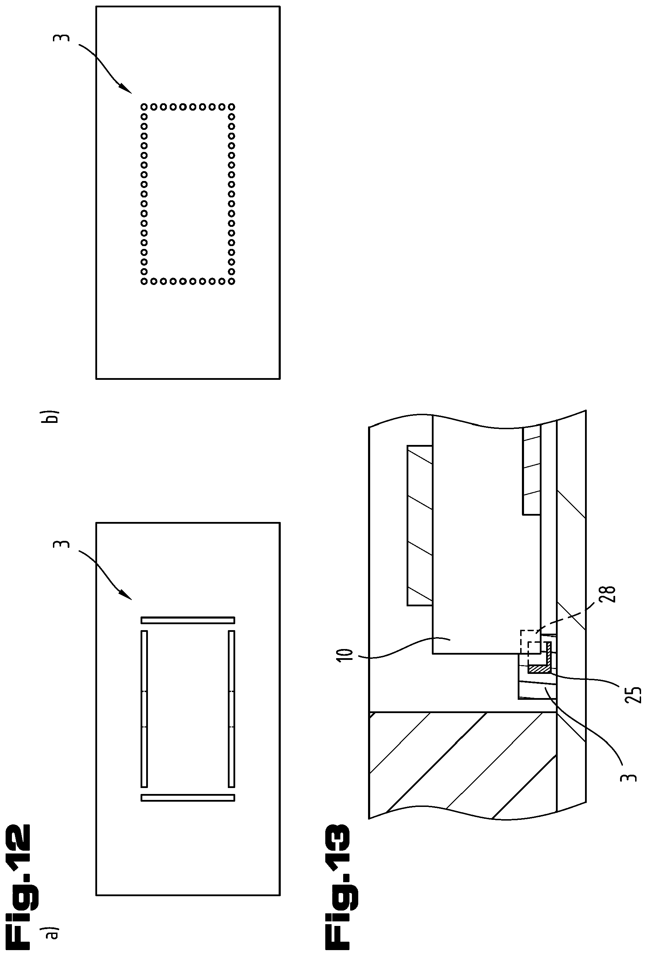

Fig. 12 shows further embodiments of the adhesive profile 3. The adhesive profile according to Fig. 12a) comprises a plurality of detached profiles. As indicated with dashed lines, the detached profiles of each side may also be composed of a plurality of profiles.

The adhesive profile according to Fig. 12b) is in form of a plurality of spots, whereby the size and the amount of the spots as well as the distance to each other can be designed variably. For example, but not limited to, the spot sizes can be 10 to 300 µm, preferably 20 to 200 µm and the distance between spots may be in a range from 10 to 700µm, preferably 20-500µm. The thickness of the adhesive profile may be in a range from 3 to 50 µm, preferably 5-30µm. A combination of spots and profiles is also possible.

Fig. 13 shows a further embodiment of the adhesive profile 3, wherein the adhesive profile 3 comprises a reinforcement profile 25, whereby the reinforcement profile 25 is preferably completely covered by the adhesive profile 3. The reinforcement profile may have a shape that corresponds to a shape or contour of the adhesive profile 3 after insertion of the component 10, for example an "L"-like shape.

Preferably, the reinforcement profile may be covered with pre-cured resin and/or one component of a two-component adhesive, to form the adhesive profile 3.

As further indicated in Fig. 13 by dashed lines, the component 10 may further comprise surface elements 28 - as already described above, wherein the reinforcement profile 25 may comprise second surface elements which are formed complementary to the surface elements 28 of the component 10, for example, they can be formed in such a way that they engage in openings of the other elements 28.

### List of reference

- 1: carrier assembly
- 2: component carrier
- 3: adhesive profile
- 4: stack
- 5: conductive layer structure
- 6: insulating layer structure
- 7: pressing tool
- 8: electrically conductive surface portion
- 9: functional part
- 10: component
- 11: first main surface
- 12: second main surface
- 13: lateral surface
- 14: first edge
- 15: second edge
- 16: space
- 17: material
- 18: adhesive profile
- 19: base layer
- 20: temporary layer
- 21: distance
- 22: height
- 23: thickness
- 24: surface
- 25: reinforcement profile
- 26: first angle
- 27: second angle
- 28: surface elements

## Claims

1. A component carrier assembly (1) comprising:
- a component carrier (2) comprising a stack (4) of at least one electrically conductive layer structure (5) and at least one electrically insulating layer structure (6), and
- a component (10), said component being at least partially embedded within the stack (4) and comprising a first main surface (11), a second main surface (12) opposed to the first main surface (11), and at least one lateral surface (13) connecting the first main surface (11) and the second main surface (12) with each other, wherein a first edge (14) is formed where the first main surface (11) and the at least one lateral surface (13) meet and a second edge (15) is formed where the second main surface (12) and the at least one lateral surface (13) meet,
wherein an adhesive profile (3) is provided in the region of the first edge (14) of the component (10).

2. A component carrier according to claim 1, wherein the second edge (15) is free of the adhesive profile.

3. A component carrier according to one of the preceding claims, wherein the component (10) is fully embedded within the stack (4), and the second edge (15) is covered by at least one layer structure (5, 6) of the stack (4).

4. A component carrier according to one of the preceding claims, wherein the first main surface (11) and/or the second main surface (12), preferably at least the second main surface (12), comprise(s) at least one electrically conductive surface portion (8) for establishing an electrical connection to a functional part (9) of the component (10).

5. A component carrier according to one of the preceding claims, wherein the adhesive profile (3) partially covers the first main surface (11) and/or partially covers the at least one lateral surface (13).

6. A component carrier according to one of the preceding claims, wherein the adhesive profile (3) is planar on a first side and is not planar on a second side opposed to the first side, wherein preferably the second side is in contact with the component (10).

7. A component carrier according to one of the preceding claims, wherein the adhesive profile (3) is distanced from the first edge (14).

8. A component carrier according to one of the preceding claims, wherein the adhesive profile (3) has a frame shape and/or is a closed profile and/or is composed of a plurality of detached profiles and/or is in form of at least one spot, in particular a plurality of spots.

9. A component carrier according to one of the preceding claims, wherein the adhesive profile (3) encloses an internal, preferably planar, space (16).

10. A component carrier according to claim 9, wherein at least one further adhesive profile (18) is provided within the internal space (16), wherein preferably said further adhesive profile (18) connects the component (10) and a layer structure (5, 6) of the stack (4) with each other and/or surrounds a functional portion (8) of the component (10) on the first main surface (11), preferably at least one electrically conductive surface portion for establishing an electrical connection to a functional part (9) within the component (10).

11. A component carrier according to claim 9 or 10, wherein the internal space (16) is empty.

12. A component carrier according to one of the claims 10 to 11, wherein the internal space (16) is at least partially filled with a material (17) different from the material of the adhesive profile (3) is formed from..

13. A method for manufacturing a component carrier assembly (1) according to one of the preceding claims, comprising the steps of:
(a) providing a component (10), preferably an electronic component, said component comprises a first main surface (11), a second main surface (12) opposed to the first main surface (11), and at least one lateral surface (13) connecting the first main surface (11) and the second main surface (12) with each other, wherein a first edge (14) is formed where the first main surface (11) and the at least one lateral surface (13) meet and a second edge (15) is formed where the second main surface (12) and the at least one lateral surface (13) meet,
(b) providing an adhesive profile (3), in the region of the first edge (14) of the component (10),
(c) forming a component carrier (2) comprising a stack (4) of at least one electrically conductive layer structure (5) and at least one electrically insulating layer structure (6), with the component (10) being at least partially, preferably fully, embedded within the stack (4).

14. A method according to claim 13, wherein step (b) comprises applying the adhesive layer (3) to a base layer (19) and/or to the component (10), and connecting the base layer (19) and the component (10) with each other via the adhesive profile (3).

15. A method according to claim 13 or 14, wherein step (c) comprises building up the stack (4) onto the base layer (19).
